# EUROPEAN PATENT APPLICATION

(11) **EP 2 592 122 A1**
(43) Date of publication of application: **15.05.2013**
(21) Application number: 11867101.5
(22) Date of filing: 05.12.2011
(51) Int. Cl.: C09G 1/02

(54) **POLISHING LIQUID FOR POLISHING PROCESS BASED ON METAL CO AND USE THEREOF**

(30) Priority: 05.07.2011 CN 201110186116; 22.11.2011 CN 201110372757
(71) Applicant: Fudan University, Shanghai 200433 (CN)
(72) Inventor: LU, Haisheng, Yangpu District Shanghai 200433 (CN); QU, Xinping, Yangpu District Shanghai 200433 (CN); WANG, Jingxuan, Yangpu District Shanghai 200433 (CN)
(74) Representative: Tombling, Adrian George
(86) International application number: PCT/CN2011/002027
(87) International publication number: WO 2013/003991

(57) **Abstract**

The present invention discloses a slurry for chemical mechanical polishing of Co. The slurry comprises components by weight as follows, Inhibitor 0.01-2%, Oxidant 0-5%, Abrasive 0.1-10%, Complexing agent 0.001-10%, and the rest of water. The pH value of the slurries is adjusted to 3-5 by pH value adjustor. The inhibitor is chosen from one or more kinds of five-membered heterocycle compound containing S and N atoms or containing S or N atom. The oxidant is chosen one or more from H₂O₂, (NH₄)₂S₂O₈, KIO₄, KClO₅. The abrasive is chosen one or more from SiO₂, CeO₂, and Al₂O₃.The complexing agent is chosen one or more from amino acid and citric acid. The slurry in the present invention can effectively prevent Co over corrosion and reduce the polishing rate of Co in the polishing process.

## Description

### Technical Field

The present invention relates to microelectronics technology, especially relates to chemical mechanical polishing (CMP) slurries and related applications.

### Background of the Invention

With the continuous shrink of feature size in ultra large scale integrated circuits(ULSI) technology, the size of the copper interconnect structure is getting more and more smaller. To reduce the RC delay, the thickness of barrier or adhesion layer in the copper interconnect structure is getting thinner. The traditional copper barrier/adhesion layer stack-Ta/TaN is not suitable any more, as the resistivity of Ta is relatively high and copper cannot be directlyelectroplatedonto Ta. Compared with Ta, cobalt has lower resistivity and is relatively cheaper. The adhesion between Cu and Co is good. Cu can easily nucleate on Co, also copper can be directlyelectroplatedon cobalt.

Porous low k dielectrics material has been already used in the current interconnect structures. It is reported that low k can be easily damaged by plasma or polishing slurries. In current chemical mechanical polishing processing, to reduce the damage to low-k dielectrics, most of the current slurries used for copper and barriers are acidic. But it is observed that copper and cobalt easily suffered from dissolution in acidic solution containing oxidant (H₂O₂). This makes the polishing rate of copper and cobalt is sohigh that it willinduce the dishing of copper line. The dissolution of the cobalt adhesion layer on the sidewall of the copper interconnect structure can lead to the delamination of copper lines and cause reliabilityproblem.Soadding effective inhibitors in the acid slurry is very important, which can reduce the polishing rate of Co, and prevent the dissolution of Co layer, along the sidewall of the copper interconnect structure.

### Description of the Invention

The present invention is to provide a kind of slurry used for chemical mechanical polishing in microelectronics technology. The slurries of the present invention can effectively inhibit the cobalt corrosion rate in the acid slurry, which can prevent the reliability problem caused by over polishing or corrosion.

To achieve the said object, the present invention provides a kind of slurry for chemical mechanical polishing of cobalt, which comprises components by weight as follows, inhibitor 0.01-2%, oxidant 0-5%, abrasive 0.1-10%, complexing agent 0.001-10%, and the rest of water.The pH value of the slurries is adjusted to 3-5 by pH value adjustor.

The inhibitor is chosen one or more from the five-membered heterocycle compound containing S and N atoms or containing S or N atom, and their derivatives. The role of the inhibitor is to reduce the corrosion rate of Cu and Co in the slurry, which can improve the efficiency of planarization , reduce the dishing defects and prevent the dissolution of adhesion layer along the sidewall of the interconnect structure.

The oxidant is chosen one or more from H₂O₂, (NH₄)₂S₂O₈, KIO₄, KClO₅. The role of oxidant is to oxidize Cu, Co and the barrier metal into the corresponding metal oxides, hydroxides or ions. Among all the oxidants, the best choice is H₂O₂. The weight proportion of the oxidant in the slurry is in the range of 0-5%, and the best weight proportion is 0.5%-5%.

The abrasive is chosen one or more from SiO₂, CeO₂, and Al₂O₃. The role of abrasive is to remove the metal or metal reaction products which contact with abrasive particles through mechanical friction force. Among all the abrasives, the best choice is colloidal SiO₂. The size of the abrasive particles has influence on the polishing rate and surface roughness. In the present invention, the size of the abrasive is in the range of 10-100nm.

The complexing agent is chosen one or more from amino acid and citric acid. The role of the complexing agent is to react with the metal ions on the metal surface or in the slurry, which reduces the metal particles in the slurry and prevents the metal ions contamination.

Said slurry for chemical mechanical polishing of cobalt, therein the slurries have the list proportion of components by weight: inhibitor 0.01-1%, oxidant 0.5-2%, abrasives 1-5%, complexing agent 0.4%, and the rest of water.

Said slurry for chemical mechanical polishing of cobalt, therein the chosenfive-membered heterocycle compound as inhibitors has two heteroatoms in ring. More detailedly speaking, the inhibitor can be chosen one or more from Benzotriazole, 2-mercaptothiazole, 2-mercaptobenzothiazole, imidazole, 2-Aminobenzimidazole, 2-Mercaptobenzimidazole and 2-Methylbenzimidazole. Among all the inhibitors, the best choice is Benzotriazole and 2-mercaptothiazole, Benzotriazole and 2-mercaptothiazole can effectively prevent the corrosion of Cu and Co.

Said slurry for chemical mechanical polishing of cobalt, therein the chosen complexing agent can be one or more kinds of amino acid, such as glycine, glutamic, leucine and arginine acid. The complexing agent can also be other organic acid, such as citric acid. The best choice is glycine as complexing agent.

Said slurry for chemical mechanical polishing of cobalt, therein the pH value adjustor is chosen one or more from nitric acid, sulphuric acid, dilute acetic acid, hydrochloric acid, potassium hydroxide, sodium hydroxide, sodium carbonate and sodium bicarbonate. The best choices are nitric acid and potassium hydroxide.

In the present invention, we also provide the application of the slurries on chemical mechanical polishing of Co technology. In integrated circuits, Co is used as adhesion or barrier layer for copper interconnects, while Co can also be used as nano-crystalline in memory device and metal gate in MOSFET. All the use of Co, cobalt alloy and cobalt compounds in the electric circuit, and the process needing polishing process, are included in the applications of the present invention.

The provided slurries in the present invention have the pH value in the range of 3-5. If the pH value of the slurry is too low, especially when the pH value is lower than 2, the CMP slurry can causecorrosion on the copper lines and the polishing equipment. If the pH value is in the range of 6-8, the SiO₂ abrasives are not stable. If the pH value of the slurry is very high, especially when the pH value is higher than 9, the slurries can damage the low-k dielectrics. So in the present invention, the pH values of the slurries are adjusted in the range of 3-5.

Theslurries for chemical mechanical polishing of Co in the present invention can effectively inhibit Co corrosion rate and reduce the polishing rate of Co, which can effectively reduce the defects after polishing process.

### Brief Description of the Figures

Figure 1a is the cross-sectional schematic structure of the dual damascene structure before polishing. Figure 1b is the cross-sectional schematic structure of the dual damascene structure after polishing.
Figure 2a is the compared potentiodynamic polarization plots of Co in the slurries(pH=3) in embodiment 1 and contrast 1. Figure 2b is the compared potentiodynamic polarization plots of Co in the slurries (pH=5) in embodiment I and contrast 1.
Figure 3 is the polishing rate of Co as a function of Benzotriazole concentration in the slurries in embodiment 2.

### The best method of applying the present invention

Combined with figures and embodiments, the best method of applying the present invention is described as following:

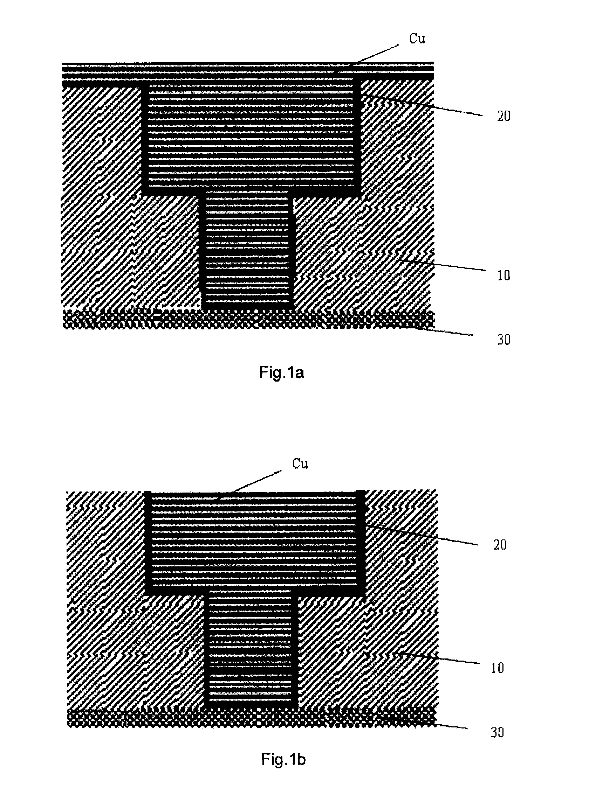

The method of applying the slurries in the present invention is similar as the applying of traditional slurries. In the polishing process, wafer is held face down by the polishing head on the polishing pad, and the slurries are pumped on the polishing pad and is spread uniformly on the wafer surface withthe rotation of polishing platen. The copper and adhesion/barrier layers on the top of the dielectrics are polishedaway as the pressure is added between wafer and polishing pad, withthe rotation of polishing head and platen. Itshould be noticed that, the method of applying the slurries described above is based on the traditional polishing equipments in this field. For the special polishing equipment, reasonably adjusting the applying method based on the real case can also achieve the role of chemical mechanical planarization. Figure 1a is the cross-sectional schematic structure of the dual damascene structure before polishing. Figure 1b is the crosssectional schematic structure of the dual damascene structure after polishing by using the slurries in the present invention. In Figure 1a and 1b, dielectrics 10 could be silicon dioxide, or low-k dielectrics. The materials of copper adhesion/barrier layer 20 could be stack containing Co and metal nitrides or metal carbon nitrides, such as Co/TaN, Co/TiN, Co/TaCN, Co/TiCN, or could be a single cobalt alloy layer, such as CoMo, CoTa, CoTiand CoW. The method of depositing adhesion/barrier layer could be Physical vapor deposition (PVD), Atomic layer deposition(ALD), or chemical vapor deposition(CVD). The material of etch stop layer 30 could be SiN, SiC, SiCN and other hard etching dielectrics materials. By using the slurries in the present invention, the excess copper and the adhesion layer and barrier layer 20 above dielectrics 10 are removed, and the structure shown in Fig 1a is changed into the structure shown in Fig 1b. Through the following embodiments the method of applying the slurries in the present invention is further described.

### Embodiment 1

The components of slurries: 1wt% colloidal SiO_{2;} 0.75wt% glycine; 0.12wt% 2-mercaptothiazole; and the rest of water. Using the diluted nitric acid and potassium hydroxide to adjust the pH value to 3.

The polishing equipment and mechanical parameters: the polisher is CP-4 bench top polisher made by CETR Company in this embodiment. The polishing pressure is 2psi, flow rate is 100ml/min, and rotation rate is 150rpm for both of polishing head and platen.

### Contrast 1

The slurries is the same as those in embodiment 1 except without 2-mercaptothiazole; The polishing equipment and mechanical parameters are also the same as those in embodiment 1.

Table 1 lists the corrosion rate and polishing rate of Co in embodiment 1 and Contrast 1.

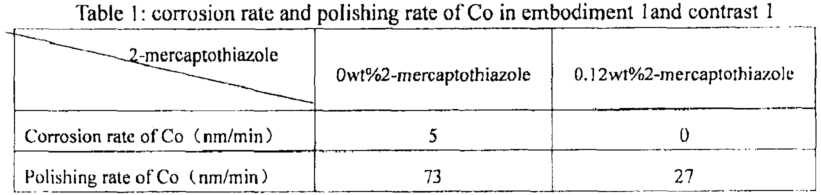

Shown in table 1, after adding 2-mercaptothiazole in the slurry, the polishing rate and corrosion rate of Co are obviously reduced. As in the real interconnect structure. the thickness of the adhesion layer is notgreaterthan 5nm, preventing the corrosion of Co is very important. In embodiment 1, by adding 2-mercaptothiazole in the slurry, the corrosion rate of Co is controlled to a low value and the polishing rate of Co is controlled to 27nm/min. this indicates 2-mercaptothiazole is a good inhibitor for Co corrosion.

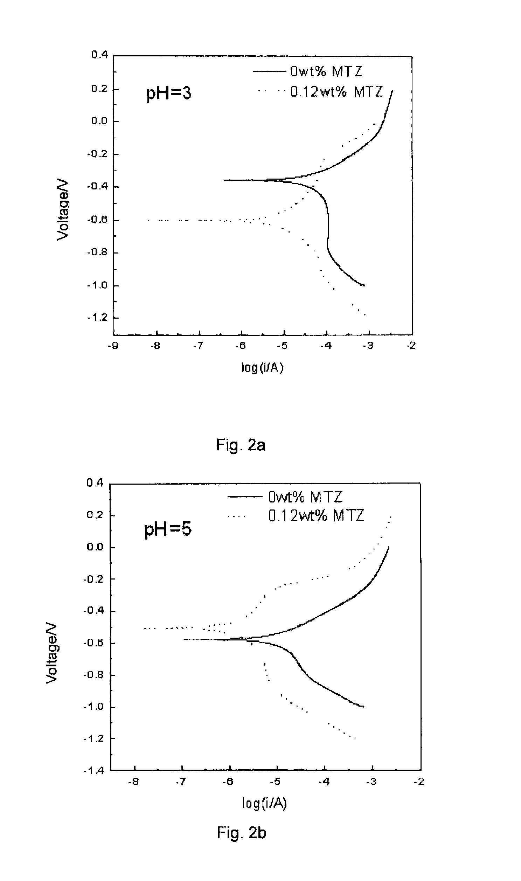

Figure 2a is the compared potentiodynamic polarization plots of Co in the slurries(pH=3) in embodiment 1 and contrast 1. Figure 2b is the compared potentiodynamic polarization plots of Co in the slurries (pH=5) in embodiment 1 and contrast 1. From figure 2a and figure 2b, we can see that both of the anodic and cathodic current are reduced obviously no matter the pH value of slurry is at 3 or 5 after adding 0.12wt% 2-mercaptothiazole, and corrosion current also reducesobviously. There is a passivation region on the anodic potentiodynamic polarization plots of Co in the slurries containing 0.12wt% 2-mercaptothiazole, and these indicate 2-mercaptothiazole can adsorb on the surface of Co and then prevent Co corrosion.

### Embodiment 2

The components of slurries; 5wt% colloidal SiO₂: 0.5wt% H₂O₂; 0.75wt% glycine; 0-0.24wt% Benzotriazole; and the rest of water. The pH value of the slurry is adjust to 5. The concentrations of Benzotriazole are controlled to 0.06wt%, 0.12wt%, 0.18wt%, 0.24wt% for all the slurries.

The polishing equipment and mechanical parameters: the polisher is CP-4 bench top polisher made by CETR Company in this embodiment. The polishing pressure is 2psi, flow rate is 100ml/min, and rotation rate is 150rpm for both of polishing head and platen.

Table 2 lists the corrosion rate of Co in the slurries with different concentrations of Benzotriazole.

**Table 2: corrosion rate of Co in embodiment 2**

| | Concentrations of Benzotriazole (wt%) | | | | |
|---|---|---|---|---|---|
| | 0 | 0.06 | 0.12 | 0.18 | 0.24 |
| Corrosion rate of Co (nm/min) | 50 | 14 | 9 | 6 | 2 |

From the data in table 2, we can see that the corrosion rate of Co is decreased as the increase of concentration of Benzotriazole. When the concentration of Benzotriazole is up to 0.24wt%, the corrosion rate of Co is reduced to 2nm/min. Thisindicates that Benzotriazole is a good inhibitor for Co corrosion. The mechanism of Benzotriazole inhibiting Co corrosion could be described asthe adsorption of Benzotriazole on Co surface and then preventing the contact between Co and the slurry, finally preventing the corrosion of Co.

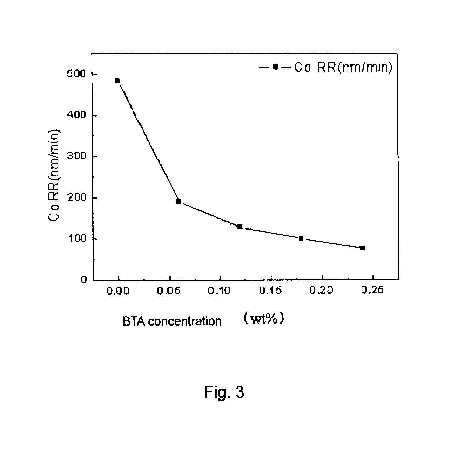

Figure 3 shows the polishing rate of Co as a function of concentrations of Benzotriazole in embodiment 2. As it is shown in Fig 3, the polishing rate of Co is reduced steadily as the increase of Benzotriazole concentration. When the Benzotriazole concentration is up to 0.24wt%, the polishing rate is reduced from 484nm/min to 75nm/min. and the corrosion rate of Co is small(2nm/min) when Benzotriazole concentration is 0.24wt%. The polishing rate of 75nm/min is enough for polishing the Co or Co alloy adhesion layer with thickness less than 5nm.

### Example 3-8

The components of the slurries (the rest is water) and the experimental data of embodiments 3-8 are listed in table 3.
Table 3: components of the slurries and experiment results of embodiments

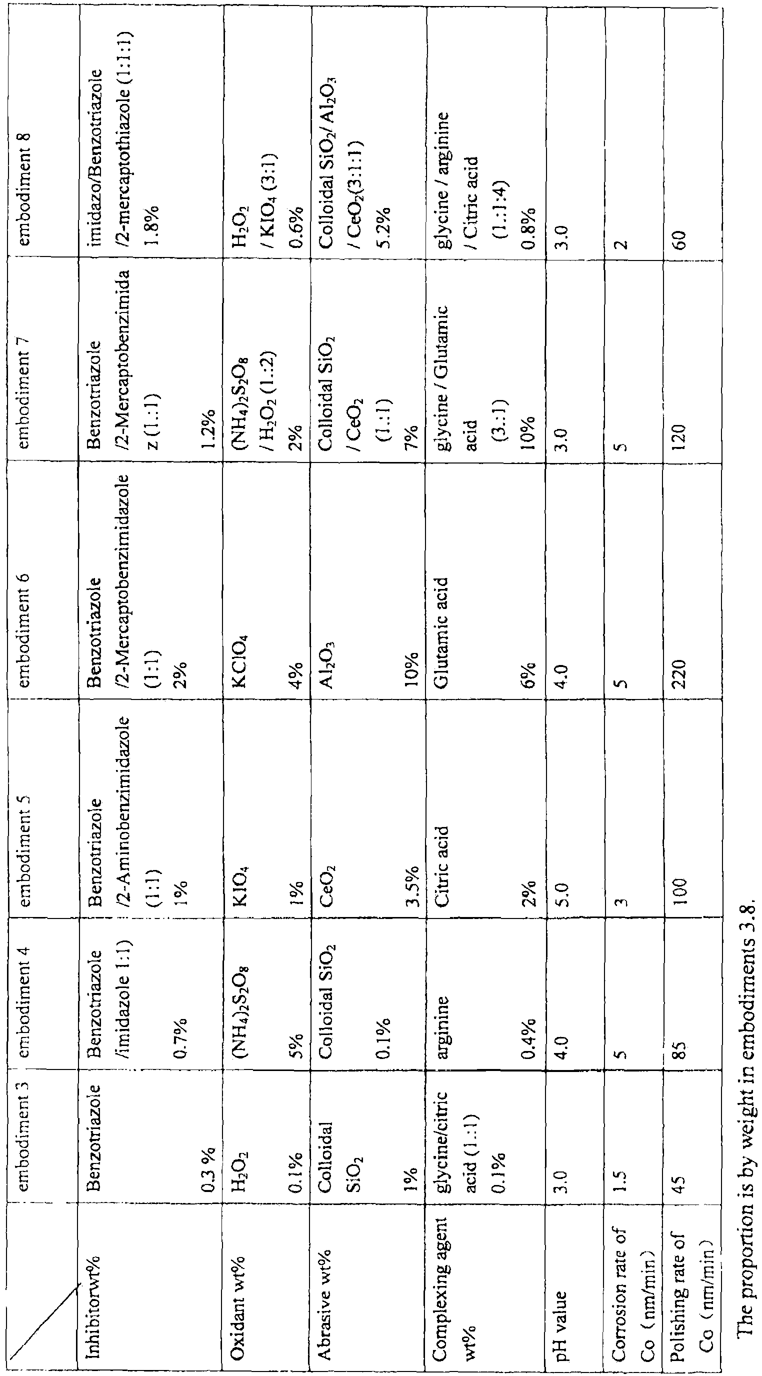

The present invention involves a polishing technology using Co or Co alloy as a metal layer in the integrated circuit. In integrated circuit, Co is mainly used as a barrier layer or adhesion layer for copper metallization, but Co could also be used as nano-crystalline in memory devises, self-aligned silicide and metal gate for MOSFET. All the use of Co, cobalt alloy and cobalt compounds in the electric circuits, and the processes needing polishing process, are included in the applications of the present invention.

Although the content of the present invention has been detailed introduced by the embodiments above, we should notice that the description about the present invention above should not be a limitation for the present invention. The expert in this filed can change or replace the present invention after reading the content above. So the protected range of this invention should be limited by the claims of the present invention.

## Claims

1. A slurry for chemical mechanical polishing of Co, comprises components by weight as follows, inhibitor 0.01-2%, oxidant 0-5%, abrasive 0.1-10%, complexing agent 0.001-10%, and the rest of water; the pH value of the slurry is adjusted to 3-5 by pH value adjustor;
said inhibitor is chosen from one or more kinds of five-membered heterocycle compound containing S and N atoms or containing S or N atom;
said oxidant is chosen one or more from H₂O₂, (NH₄)₂S₂O₈, KIO₄, KClO₅;
said abrasive is chosen one or more from SiO₂, CeO₂, and Al₂O₃; saidcomplexing agent is chosen one or more from amino acid and citric acid.

2. The slurry for chemical mechanical polishing of Co of claim 1, wherein said slurry comprises components by weight as follows, inhibitor 0.01-1%, oxidant 0.5-2%, abrasive 1-5%, complexing agent 0.4%, and the rest of water.

3. The slurry for chemical mechanical polishing of Co of claim 1 or claim 2, wherein said five-membered heterocycle compound chosen as inhibitor has two heteroatoms in ring.

4. The slurry for chemical mechanical polishing of Co of claim 3, wherein said inhibitor is chosen one or more from Benzotriazole, 2-mercaptothiazole, 2-mercaptobenzothiazole, imidazole, 2-Aminobenzimidazole, 2-Mercaptobenzimidazole and 2-Methylbenzimidazole.

5. The slurry for chemical mechanical polishing of Co of claim 4, wherein said inhibitor is mixing of Benzotriazole and 2-mercaptothiazole.

6. The slurry for chemical mechanical polishing of Co of claim 1 or claim 2 or claim 4 or claim 5, wherein said particle size of the abrasive is in the range of 10-100nm.

7. The slurry for chemical mechanical polishing of Co of claim 1 or claim 2 or claim 4 or claim 5, wherein said complexing agent is chosen one or more from glycine, glutamic, leucine and arginine acid.

8. The slurry for chemical mechanical polishing of Co of claim 7, wherein said complexing agent is glycine acid.

9. The slurry for chemical mechanical polishing of Co of claim 1, the pH value adjustor is chosen one or more from nitric acid, sulphuric acid, dilute acetic acid, hydrochloric acid, potassium hydroxide, sodium hydroxide, sodium carbonate and sodium bicarbonate.

10. The application of the slurry for chemical mechanical polishing of Co according to claim 1 in polishing process.
